Europäisches Patentamt

European Patent Office

Office européen des brevets

(11) Publication number: **0 414 562 A2**

## EUROPEAN PATENT APPLICATION

(21) Application number: **90309320.1**

(22) Date of filing: **24.08.90**

(51) Int. Cl.5: **G01N 23/223**, C30B 31/18

(30) Priority: **25.08.89 FI 894010**

(43) Date of publication of application:
**27.02.91 Bulletin 91/09**

(84) Designated Contracting States:
**DE ES FR GB IT NL**

(71) Applicant: **MICRONAS INC.**
**Kamreerinkuja 2**
**SF-02770 Espoo(FI)**

(72) Inventor: **Tammenmaa, Markku**
**Kourakuja 8 C 5**
**SF-02320 Espoo(FI)**

(74) Representative: **Lamb, John Baxter et al**
**MARKS & CLERK 57/60 Lincoln's Inn Fields**
**London WC2A 3LS(GB)**

(54) **A method of monitoring a process of growing a film of silicon dioxide doped with phosphorus.**

(57) The invention relates to a method of monitoring a process of growing a thin film of silicon dioxide doped with phosphorus, comprising growing a sample thin film by the growing process to be monitored on the surface of a substrate; and determining the relative phosphorus concentration of the thin film. In the present invention, to enable simpler determination of phosphorus concentration more rapidly and more accurately than previously, the sample thin film is grown on a substrate made of a material containing no silicon, whereby it is possible to measure the intensity of the fluorescent radiation of both phosphorus and silicon separately by an X-ray fluorescence method and to determine the proportional amount of phosphorus in the thin film as the ratio of the measured intensities. The method is calibrated by preparing standard films having equal phosphorus/silicon ratios on the same substrate material.

EP 0 414 562 A2

# A METHOD OF MONITORING A PROCESS OF GROWING A FILM OF SILICON DIOXIDE DOPED WITH PHOSPHORUS

The invention relates to a method of monitoring a process of growing a thin film of silicon dioxide doped with phosphorus, comprising growing a sample thin film by the process to be monitored on the surface of a substrate made of a material containing no silicon; measuring the intensity of the fluorescent radiation of phosphorus and silicon and determining the ratio of the intensities; calibrating the measured intensity ratio by a calibration coefficient determined by measuring the intensity of the fluorescent radiation of phosphorus and silicon from a standard film prepared on a substrate containing no silicon, the ratio of phosphorus and silicon concentrations in the standard film being known; and determining the proportional amount of phosphorus in the thin film by means of the calibrated intensity ratio.

Thin films of silicon dioxide doped with phosphorus are used widely in microcircuits, for instance, particularly to form passivation layers on a metal wiring, usually an aluminium wiring. A suitable amount of phosphorus improves the mechanical properties of an insulating layer whereas an excessive amount of phosphorus corrodes the under-lying metal wiring. A suitable amount of phosphorus is typically in the range from 4 to 8% by weight.

A thin-film growing process can be monitored by placing a suitable number of substrates in a growing apparatus so as to be able to control the entire process area in the growing apparatus. A thin film is grown on the substrate by the growing process to be monitored, and the phosphorus concentration of the thin film is then determined by a suitable technique. If the phosphorus concentration deviates from a desired value, the growing process is adjusted accordingly. Depending on the stability of the growing apparatus, it is usually sufficient under process conditions that such control measurements are performed at predetermined intervals and after possible process disturbances and maintenance of apparatus.

The phosphorus concentration of the thin film can be determined chemically or by some other suitable method of analysis. Most methods of analysis, especially the chemical ones, are usually difficult and slow, which makes them less practicable when handling great sample amounts.

One method of determining the concentration of a substance is an X-ray fluorescence method described in, e.g., *An Introduction to X-ray spectrometry*, K.L. Williams, London, 1987. In the X-ray fluorescence method, a sample is exposed to X-rays, which excite atoms contained in the sample. When the excited states are discharged, each element emits so-called fluorescent radiation at a wavelength characteristic of this particular element. The intensity of the radiation is proportional to the amount of this element in the sample.

The X-ray fluorescence method can be applied directly to a thin film formed on a substrate without destroying the sample. In the conventional method, a thin film of silicon dioxide is irradiated with X-rays, and the intensity of fluorescent radiation emitted by phosphorus is measured and compared with that of fluorescent radiation emitted by phosphorus in a standard sample. In this way the quantitative amount of phosphorus in the sample can be found out. With a thin film, however, it is additionally necessary to determine the thickness and density of the thin film to be able to calculate the proportional amount of phosphorus in the thin film. Although this method is otherwise well suited for large sample amounts, the measurement of the thickness and density of the thin film makes it slow and impairs its accuracy.

German Offenlegungsschrift 2716689 describes an X-ray fluorescence method in which the concentration and thickness of a thin film are determined as the ratio of measured intensities, and intensities obtained from a sample film are calibrated by means of intensities measured from a standard film containing the same substances in known concentrations. The standard film is a polymer film containing the substances to be measured in known concentrations. A polymer film is suitable for the purpose as it can be prepared by applying a doped polymer solution to a substrate and by drying the solution to form a film. This method, however, is not applicable in determining the phosphorus concentration of a silicon dioxide film, because attempts to find a solution which contains silicon, phosphorus and polymer, which remains stable especially at high silicon concentration levels, and which can be applied to a substrate and dried on it have not been successful. With regard to accuracy, it is, however, of importance that the thickness and concentrations of the standard film are as close as possible to the values of the sample film to be measured.

The object of the invention is to provide a new method of monitoring the phosphorus concentration of a thin film, in which the above problems are avoided and the phosphorus concentration can be determined by an X-ray fluorescence technique more simply and more accurately than previously.

This is achieved by means of a method of the type described in the preamble, which method according to the invention is characterized in that the standard film is a sodium silicate or potassium silicate film containing silicon and phosphorus in known concentrations.

When a sodium or potassium silicate solution containing phosphorus and silicon in known concentrations is used, the solution is stable and can be applied to the substrate material and dried to form a film. The silicates according to the invention are the only materials enabling the preparation of the standard films required in the invention with sufficiently high silicon concentrations.

The thin film is grown on a substrate which does not contain silicon, whereby the fluorescent radiation of silicon in addition to that of phosphorus can be measured without the risk of the radiation from the substrate distorting the measuring result. Alumina, commercially available in pure form in discs of desired size, is one extremely suitable material for use as a silicon-non-containing substrate. Such discs can be used as such as test discs when growing a PSG passivation layer on an aluminium wiring without introducing any additional materials into the process. One further major advantage of an alumina substrate is that it does not affect the fluorescence intensities of phosphorus and silicon through secondary excitation because the elements it contains are lighter than phosphorus and silicon.

The method of the invention enables the determination of the phosphorus concentration in a film of silicon dioxide without knowing the thickness and density of the sample films and disregarding any variation occurring in them. On the other hand, in addition to monitoring the phosphorus concentration, the method can also be used for monitoring the thickness of the film because the fluorescence intensity of silicon is directly proportional to the thickness of the silicon dioxide film. Accordingly, the method is very suitable for use as a control routine in a growing process, being rapid, reliable and low in costs.

Other advantages of the method include: (a) rapid and reliable calibration of the X-ray fluorescence measurements without any other methods of analysis, (b) variations in the thickness and density of the sample films do not affect the calibration, (c) the measuring method is self-checking as it always comprises the measurement of the standard sample and when appropriately measured the intensity ratio obtained from the standard sample remains constant.

The invention will now be described in greater detail by means of exemplifying embodiments with reference to the attached drawing, in which

Figure 1 is a schematic view of an X-ray fluorescence measuring arrangement;

Figure 2 shows a thin film grown on a substrate according to the invention; and

Figure 3 illustrates graphically the dependence of the ratio of the fluorescent radiation intensities of phosphorus and silicon on the phosphorus concentration.

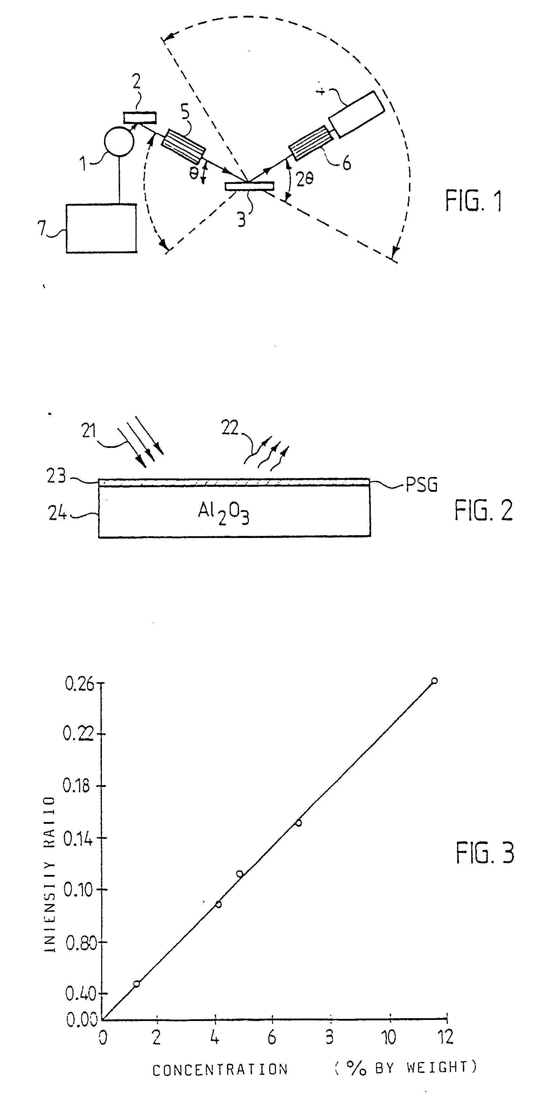

One X-ray fluorescence spectrometric measuring arrangement suited for realizing the method of the invention is shown schematically in Figure 1. The arrangement comprises an X-ray tube 1 which is supplied by a high voltage source 7. A sample 2 is irradiated by the X-ray tube. As is shown in Figure 2, the sample consists of a planar substrate 24 made of a non-silicon-containing material on which a film 23 of silicon dioxide doped with phosphorus has been grown. The film 23 of silicon dioxide doped with phosphorus P is also called phosphorus glass, abbreviated PSG. The substrate is of alumina, more precisely $Al_2O_3$. X-rays 21 impinging on the sample 2 excite the atoms of the sample and when the state of excitation is discharged, each element emits fluorescent radiation 22 at a wavelength characteristic of it. The fluorescent radiation emitted by the sample is collimated by a collimator 5 formed by a pack of metal sheets. The fluorescent radiation passed through the collimator strikes an analyzer crystal 3 which divides the fluorescent radiation into wavelengths according to Bragg's law $n = 2d\sin\theta$. The wavelength component dependent on the position of the crystal 3 is reflected from the surface of the crystal 3 to another collimator 6 which collimates the reflected wavelength component and passes it to a detector 4 which generates an electric signal proportional to the intensity of the wavelength component. By altering the position of the crystal 3, the wavelength to be detected can be varied so that the concentration of different substances in the sample can be measured.

To monitor the growing process of a PSG thin film, a suitable number of $Al_2O_3$ discs are placed in a growing apparatus in such a way that the entire process area in the growing apparatus can be tested. A thin film is then grown normally.

For the determination of the phosphorus concentration a piece suitable for the sample holder of the X-ray fluorescence measuring apparatus is broken off the discs, and the PKa and SiKa intensities are measured from the samples. Disregarding matrix effects causing nonlinearity, the measured fluorescent radiation intensities are linear functions of the amounts of material per unit area of the thin film:

$$I(P) = K(P) \cdot m(P) \qquad (1)$$

$$I(Si) = K(Si) \cdot m(Si) \qquad (2)$$

where K(P) and K(Si) are constants depending on apparatus parameters and the fluorescence yield of phosphorus and silicon, respectively, and m(P) and m(Si) denote the amount of phosphorus and silicon per unit area in the thin film. The relationship obtained between the phosphorus concentration and the measured fluorescence intensities by calibration of the ratio of the intensities I(P) and I(Si) is independent of variations in the thickness of the thin film.

$$\frac{I(P)}{I(Si)} = \frac{K(P/Si) \cdot m(P)}{m(Si)} \qquad (3)$$

$$\frac{m(P)}{m(Si)} = \frac{I(P)}{I(Si)} \cdot \frac{1}{K(P/Si)} \qquad (4)$$

It is thereby not necessary to know the thickness and density of the thin film to determine the phosphorus concentration.

The determination of the constant K(P/Si) and the quantitative analysis of the concentrations, however, require standard or control samples with chemical compositions that correspond to the composition of the sample as closely as possible. The influence of so-called matrix effects is thereby similar in the sample and in the standard sample. This is of particularly great importance in conventional X-ray fluorescence measurement applications in which the sample is effectively indefinite in thickness in view of the physical phenomena on which the measurement is based. In thin film samples, the matrix effects occurring within the film itself are of considerably less importance due to low film thicknesses. On the other hand, as the above-mentioned effectively indefinite thickness is not realized in thin film samples, conventionally prepared standard samples are not suitable for use as control samples or in calibration, because in addition to the composition the standard samples also have to correspond to the thin film samples in dimensions. Equivalently, if the matrix effects possibly caused by the substrate are properly taken into account, it is necessary that the standard thin films correspond to the samples in thickness and that they are prepared on the same substrate material as the sample films.

Starting from the above-mentioned requirements, a method belonging to the scope of the invention was developed for preparing the standards:

Aqueous solutions of sodium silicate (water glass) and neutralized phosphoric acid with known compositions are mixed in required amounts to achieve a desired phosphorus/silicon concentration ratio. A suitable amount of this mixture is poured onto a substrate of $Al_2OO_3$, and after the mixture has spread the substrate is revolved to remove excessive mixture. The remaining liquid film is dried at 80 to 100° C. Depending on the viscosity of the solution, the resulting film is thin and solid and has the same concentration ratio of phosphorus and silicon as the mixture of the solutions. So it can be used as a standard of known properties. The film thickness of the standard sample can be easily adjusted by adding water, or diluted alkali base solution if water causes precipitation, to the solution mixture. The film thickness should be within such limits that the fluorescence intensities measured from the standard samples correspond in magnitude to values measured from the proper thin film samples. Thereby the film thicknesses too are close to each other.

In the above-described method, the standard films differ from the thin-film samples in that they contain sodium which distorts the results as it absorbs PKa and SiKa radiation with different intensity. As the films, however, are very thin, this effect can be regarded as negligible. An alternative solution is to use potassium silicate or a *spin on glass* silicon chemical used in semiconductor processes in conjunction with a phosphorus chemical matching with it chemically. The above-described method is directly applicable when using potassium silicate. In the process control of the phosphorus concentration of silicon dioxide used in passivation layers, any one of these chemical systems can be used as the error caused by absorption in thin films containing light elements is rather theoretical than of any practical importance.

As Eq. (3) above describes a straight line extending through an origin, the preparation and measurement of one standard sample is, in practice, sufficient to determine the constant K(P/Si). On the other hand, if a series of standard samples is prepared, the validity of Eq. (3) can be seen from the linearity of the measured values. Figure 3 shows a calibration line obtained as described above. The horizontal axis represents the phosphorus concentration in percentages by weight and the vertical axis represents the ratio of the P and Si intensities. The good applicability of the linear model shows that the matrix effects are not notable although the standard films are made of sodium silicate.

In the present invention, standard samples are used in the determination of phosphorus concentration even after the completion of the calibration of the measuring system by means of them. Each sample is thereby measured together with one or more standard samples and the ratio of the phosphorus and silicon intensities measured from the sample are compared with the ratio calculated from the standard sample, whereby the following equation gives accurately the phosphorus concentration

$$m_n(P) = \frac{I_n(P)}{I_n(Si)} \cdot \frac{I_s(Si)}{I_s(P)} \cdot m_s(P) \qquad (5)$$

where $I_n(P)$ and $I_n(Si)$ are intensities measured from the sample; $I_s(P)$ and $I_s(Si)$ are intensities measured from the standard; $m_s(P)$ is the known phosphorus concentration of the standard sample; and $m_n(P)$ is the phosphorus concentration of the sample to be analyzed.

The figures and the description related to them are only intended to illustrate the present inven tion. In its details the method of the invention may vary within the scope of the attached claims.

## Claims

1. A method of monitoring a process of growing a thin film of silicon dioxide doped with phosphorus, comprising

growing a sample thin film by the process to be monitored on the surface of a substrate made of a material containing no silicon;

measuring the intensity of the fluorescent radiation of phosphorus and silicon and determining the ratio of the intensities;

calibrating the measured intensity ratio by a calibration coefficient determined by measuring the intensity of the fluorescent radiation of phosphorus and silicon from a standard film prepared on a substrate containing no silicon, the ratio of phosphorus and silicon concentrations in the standard film being known; and

determining the proportional amount of phosphorus in the thin film by means of the calibrated intensity ratio, **characterized** in that said standard film is a sodium silicate or potassium silicate film containing silicon and phosphorus in known concentrations.

2. A method according to claim 1, **characterized** in that the standard film is prepared by applying a solution containing sodium or potassium silicate and phosphoric acid with known concentrations of silicon and phosphorus to a substrate material and by drying it into a film.

3. A method according to claim 1 or 2, **characterized** in that the substrate material is alumina $Al_2O_3$.

FIG. 1

FIG. 2

FIG. 3